(19) Europäisches Patentamt
European Patent Office
Office européen des brevets

(11) **EP 3 001 208 B1**

(12) **FASCICULE DE BREVET EUROPEEN**

(45) Date de publication et mention
de la délivrance du brevet:
**23.08.2017 Bulletin 2017/34**

(51) Int Cl.:
**G01R 31/02** *(2006.01)*  **G01R 21/133** *(2006.01)*
**G01R 22/06** *(2006.01)*  **G01R 31/08** *(2006.01)*

(21) Numéro de dépôt: **15183493.4**

(22) Date de dépôt: **02.09.2015**

(54) **SYSTÈME DE DÉTECTION D'UN DÉFAUT ÉLECTRIQUE ET PROCÉDÉ ASSOCIÉ**

SYSTEM ZUM ERKENNEN EINER ELEKTRISCHEN STÖRUNG, UND ENTSPRECHENDES VERFAHREN

SYSTEM FOR DETECTING AN ELECTRICAL DEFECT AND ASSOCIATED METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.09.2014 FR 1459150**

(43) Date de publication de la demande:
**30.03.2016 Bulletin 2016/13**

(73) Titulaire: **Schneider Electric Industries SAS**
**92500 Rueil-Malmaison (FR)**

(72) Inventeurs:
• **COUTELOU, Olivier**
**38050 Grenoble Cedex 09 (FR)**
• **CLEMENCE, Michel**
**38050 Grenoble Cedex 09 (FR)**
• **BERTOCCHI, Jean-Luc**
**38050 Grenoble Cedex 09 (FR)**

(74) Mandataire: **Lavoix**
**2, place d'Estienne d'Orves**
**75441 Paris Cedex 09 (FR)**

(56) Documents cités:
WO-A1-2010/076406   FR-A1- 2 991 057
US-A1- 2009 088 989

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

La présente invention concerne un système de détection d'un défaut électrique dans une installation électrique comprenant plusieurs conducteurs électriques, le système comprenant :

- au moins deux modules de mesure, chaque module de mesure comportant des premiers moyens radioélectriques de communication, un capteur de mesure de chaque grandeur électrique associée à un conducteur électrique correspondant et une première horloge définie par un premier instant initial et une première fréquence d'horloge, chaque valeur mesurée étant propre à être associée à un premier instant de mesure, déterminé par rapport au premier instant initial et en fonction de la première fréquence,
- une unité d'acquisition des valeurs mesurées, comportant des deuxièmes moyens radioélectriques adaptés pour communiquer avec les premiers moyens radioélectriques de communication.

La présente invention concerne également un procédé de détection d'un défaut électrique dans une installation électrique.

Dans le domaine de la détection de défauts électriques au niveau d'une installation électrique comprenant plusieurs conducteurs électriques et notamment au niveau d'un réseau aérien de transport d'électricité, il est connu d'utiliser un système de détection d'un défaut électrique à partir de mesures de courant effectuées au niveau des différents conducteurs électriques. Un tel système comprend alors un module de mesure du courant pour chaque conducteur électrique et une unité d'acquisition des valeurs mesurées. Chaque module de mesure comporte des premiers moyens radioélectriques de communication, un capteur de mesure du courant traversant le conducteur électrique correspondant et une horloge définie par un instant initial et une fréquence d'horloge. Chaque valeur mesurée du courant est alors associée à un instant de mesure, déterminé par rapport à l'instant initial et en fonction de la fréquence d'horloge. En outre, l'unité d'acquisition comporte des deuxièmes moyens radioélectriques de communication adaptés pour communiquer avec les premiers moyens radioélectriques de communication.

Le système de détection est, par exemple, destiné à récupérer les valeurs de courant mesurées par chaque module de mesure et à les sommer pour confirmer ou non l'apparition du défaut électrique, afin d'isoler le défaut électrique. Afin que la somme des courants donne un résultat exploitable et représentatif de la réalité, il est nécessaire que les valeurs de courant sommées soient mesurées au même instant.

A cet effet, dans les systèmes de détection connus, l'unité d'acquisition transmet simultanément à chaque module de mesure un message de synchronisation. Chaque module de mesure redémarre la mesure du courant traversant le conducteur électrique correspondant au moment de la réception du message de synchronisation et réalise un échantillonnage des valeurs de courants mesurées en fonction de la fréquence d'horloge et de l'instant de réception du message de synchronisation.

Cependant, dans de tels systèmes, la détection d'un défaut électrique est complexe à réaliser et imprécise, et la quantité d'informations traitées et échangées entre les modules de mesure et l'unité d'acquisition est importante. Ceci entraîne notamment une consommation importante et des risques de non-réception de certaines informations transmises. De tels systèmes de détection ne permettent notamment pas de garantir la détection d'un défaut électrique dans un réseau électrique aérien triphasé à neutre compensé. En effet, il est à noter que dans un tel réseau le courant de défaut est faible comparativement à un courant de charge, circulant sur les conducteurs électriques en direction d'une charge à alimenter, ce qui empêche la détection du défaut électrique via les systèmes de détection connus. La demande FR 2 991 057 A1 (29 novembre 2013) décrit un système de mesure de l'énergie électrique dans un installation électrique comprenant au moins deux modules de mesure et une unité d'acquisition des valeurs mesurés.

Le but de l'invention est donc de proposer un système de détection d'un défaut électrique dans une installation électrique comprenant plusieurs conducteurs électriques permettant d'améliorer et de faciliter la détection du défaut électrique, ainsi que de réduire la quantité d'informations traitées et échangées entre les modules de mesure et l'unité d'acquisition.

A cet effet, l'invention a pour objet un système de détection du type précité, caractérisé en ce que le système comprend, pour au moins l'un des modules de mesure, un organe de détection du défaut électrique associé au conducteur électrique correspondant, l'organe de détection étant propre à déterminer la valeur d'un instant de détection du défaut par rapport au premier instant initial et en fonction de la première fréquence,
en ce que, l'unité d'acquisition comprend :

- des premiers moyens de détermination de la valeur de chaque instant de détection par rapport au premier instant initial et en fonction de la première fréquence des autres modules de mesure,
- des moyens d'acquisition pour chaque module de mesure des seules valeurs mesurées pour lesquelles le premier instant de mesure est compris dans un premier intervalle temporel prédéfini correspondant, chaque premier intervalle correspondant comprenant la valeur de l'instant de détection déterminée pour ledit module de mesure auquel il est associé.

Grâce à l'invention, les valeurs de chaque grandeur électrique mesurées par chaque module de mesure au moment de l'instant de détection sont précisément identifiées, puisque la valeur de l'instant de détection est précisément déterminée, par rapport au premier instant initial et en fonction de la première fréquence d'horloge de la première horloge de chaque module de mesure. Ceci permet de prendre en compte les différences de valeurs entre le premier instant initial de chaque première horloge et entre la première fréquence de chaque première horloge et d'acquérir, pour chaque module de mesure, les valeurs mesurées autour d'un même instant absolu correspondant à la détection du défaut électrique supposé. Les valeurs acquises par l'unité d'acquisition pour chaque module de mesure ont donc été mesurées sensiblement au même instant et au moment de l'apparition du défaut électrique supposé, ce qui permet de faciliter et d'améliorer la détection du défaut électrique à partir de ces valeurs, et avantageusement de confirmer l'apparition du défaut électrique à partir de ces valeurs. De plus, le fait que les seules valeurs acquises soient comprises dans des intervalles prédéfinis permet de réduire la quantité d'informations traitées et échangées entre les modules de mesure et l'unité d'acquisition.

Selon des aspects avantageux de l'invention, le système de détection comprend en outre une ou plusieurs des caractéristiques suivantes, prises isolément ou selon toutes les combinaisons techniquement admissibles :

- l'unité d'acquisition comporte une deuxième horloge définie par un deuxième instant initial et une deuxième fréquence d'horloge, et dans lequel les premiers moyens de détermination sont propres à déterminer la valeur de l'instant de détection, par rapport au deuxième instant initial et en fonction de la deuxième fréquence ;
- l'unité d'acquisition comporte une deuxième horloge définie par un deuxième instant initial et une deuxième fréquence d'horloge, et dans lequel l'unité d'acquisition comprend des deuxièmes moyens de détermination, pour chaque valeur acquise, d'un deuxième instant de mesure de ladite valeur, déterminé par rapport au deuxième instant initial et en fonction de la deuxième fréquence ;
- l'unité d'acquisition comprend des premiers moyens de calcul propres à calculer une suite de troisièmes instants régulièrement espacés et déterminés par rapport au deuxième instant initial et en fonction de la deuxième fréquence, et des deuxièmes moyens de calcul propres à estimer la valeur de chaque grandeur électrique mesurée, aux troisièmes instants et en fonction des valeurs acquises et des deuxièmes instants de mesure ;
- la ou les grandeurs électriques sont choisies parmi une tension et un courant ;
- l'unité d'acquisition comprend des moyens de confirmation adaptés pour confirmer l'apparition du défaut électrique en fonction des valeurs acquises et des deuxièmes instants de mesure associés ;
- chaque module de mesure comprend des moyens de génération d'un message cyclique, comportant une première variable fonction d'un instant d'émission du message cyclique par rapport au premier instant initial et selon la première fréquence, et des moyens de transmission du message cyclique à destination de l'unité d'acquisition, dans lequel l'unité d'acquisition est propre à déterminer un instant de réception du message cyclique, par rapport au deuxième instant initial et en fonction de la deuxième fréquence, et dans lequel pour chaque module de mesure, l'unité d'acquisition comprend des troisièmes moyens de calcul d'un ratio entre, d'une part, une première durée entre deux instants d'émission successifs et, d'autre part, une deuxième durée entre deux instants de réception correspondants ;
- chaque module de mesure muni d'un organe de détection comprend des quatrièmes moyens de calcul d'une durée de transmission, les quatrièmes moyens de calcul étant propres à associer à chaque instant de détection un instant d'émission suivant, après l'instant de détection, et à calculer la durée de transmission entre l'instant de détection et l'instant d'émission suivant, le message cyclique comprenant la durée de transmission ;
- les premiers moyens de détermination sont propres à calculer, par rapport au deuxième instant initial et en fonction de la deuxième fréquence, la valeur de l'instant de détection en fonction de la durée de transmission, de la valeur de l'instant de réception et du ratio ;
- les premiers moyens de détermination sont propres à calculer, pour chaque module de mesure, une troisième durée entre l'instant de réception d'un dernier message cyclique transmis par le module de mesure et l'instant de détection calculé par rapport au deuxième instant initial et en fonction de la deuxième fréquence, et à déterminer, par rapport au premier instant initial et à la première fréquence de chaque module de mesure, la valeur de l'instant de détection en fonction de l'instant d'émission du dernier message cyclique, du ratio correspondant et de la troisième durée correspondante ;
- l'unité d'acquisition comprend, pour chaque module de mesure, des moyens de définition du premier intervalle prédéfini correspondant en fonction du ratio correspondant, d'une troisième durée correspondante et du temps d'émission d'un dernier message cyclique par rapport au premier instant initial et en fonction de la première fréquence ;
- chaque module de mesure comprend un organe d'échantillonnage propre à échantillonner les valeurs mesurées de chaque grandeur électrique selon une fréquence d'échantillonnage, un numéro d'échantillon et le premier instant de mesure correspondant étant associé à chaque échantillon,

les moyens d'acquisition sont propres à transmettre à chaque module de mesure, via un message de sélection, le premier intervalle correspondant, et

chaque module de mesure est propre à transmettre à l'unité d'acquisition, via un message d'acquisition, les échantillons dont le premier instant est compris dans le premier intervalle correspondant reçu et au moins une deuxième variable relative au premier instant de mesure de l'un des échantillons.

L'invention a également pour objet un procédé de détection d'un défaut électrique dans une installation électrique comprenant plusieurs conducteurs électriques, le procédé étant mis en oeuvre à l'aide d'un système de détection du défaut électrique comportant :

- au moins deux modules de mesure, chaque module de mesure comportant des premiers moyens radioélectriques de communication, un capteur de mesure de chaque grandeur électrique associée à un conducteur électrique correspondant et une première horloge définie par un premier instant initial et une première fréquence d'horloge, chaque valeur mesurée étant propre à être associée à un premier instant de mesure déterminé par rapport au premier instant initial et en fonction de la première fréquence,
- une unité d'acquisition des valeurs mesurées, comportant des deuxièmes moyens radioélectriques de communication adaptés pour communiquer avec les premiers moyens radioélectriques,

caractérisé en ce que le procédé comprend, pour au moins l'un des modules de mesure, les étapes suivantes

- la détection du défaut électrique sur le conducteur électrique correspondant,
- la détermination de la valeur d'un instant de détection du défaut par rapport au premier instant initial et en fonction de la première fréquence,

et en ce que le procédé comprend les étapes suivantes :

- la détermination par l'unité d'acquisition de la valeur de chaque instant de détection par rapport au premier instant initial et en fonction de la première fréquence des autres modules de mesure,
- l'acquisition, par l'unité d'acquisition et pour chaque module de mesure, des seules valeurs mesurées pour lesquelles le premier instant de mesure est compris dans un premier intervalle temporel prédéfini correspondant, chaque premier intervalle correspondant comprenant la valeur de l'instant de détection déterminée pour ledit module de mesure.

Avantageusement, le procédé de détection comprend en outre une ou plusieurs des caractéristiques suivantes, prises isolément ou selon toutes les combinaisons techniquement admissibles :

- l'unité d'acquisition comporte une deuxième horloge définie par un deuxième instant initial et une deuxième fréquence d'horloge, et dans lequel, lors de l'étape d'acquisition le procédé comprend l'étape suivante :
- le calcul, pour chaque valeur acquise, d'un deuxième instant de mesure de la valeur, déterminé par rapport au deuxième instant initial et en fonction de la deuxième fréquence ;
- précédemment à l'étape de détermination, le procédé comprend une étape d'identification, au cours de laquelle l'unité d'acquisition vérifie si l'un des modules de mesure a détecté ou non le défaut électrique, et dans lequel les étapes de détermination, et d'acquisition sont réalisées seulement si l'apparition du défaut électrique est identifiée lors de l'étape d'identification.

L'invention sera mieux comprise et d'autres avantages de celle-ci apparaîtront à la lumière de la description qui va suivre, donnée uniquement à titre d'exemple non limitatif, et faite en se référant aux dessins annexés sur lesquels :

- la figure 1 est une représentation schématique d'un système de détection selon l'invention, comprenant des modules de mesure et une unité d'acquisition, et installé sur une installation électrique triphasée ;
- la figure 2 est un chronogramme représentant l'ordonnancement de messages échangés entre l'unité d'acquisition et les modules de mesure de la figure 1 ; et
- la figure 3 est un organigramme des étapes d'un procédé de détection selon l'invention.

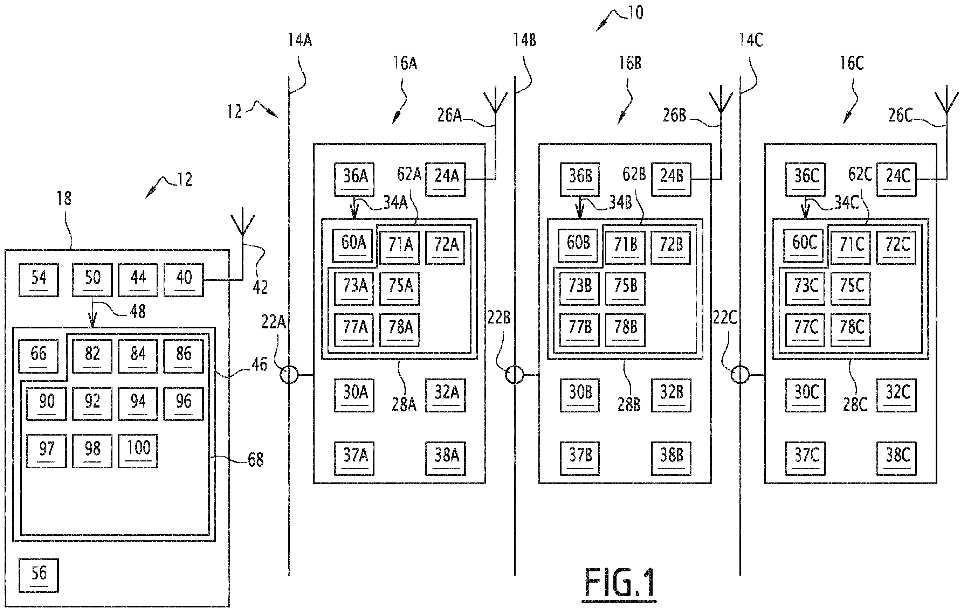

Sur la figure 1, une installation électrique triphasée 10, sur laquelle est installé un système 12 de détection d'un défaut électrique est représentée.

L'installation électrique 10 correspond, par exemple, à un réseau aérien de transport d'électricité et comprend un premier 14A, un deuxième 14B et un troisième 14C conducteurs électriques. L'installation électrique 10 est, par exemple, destinée à alimenter une charge électrique, non représentée.

Le système de détection 12 comprend un premier 16A, un deuxième 16B et un troisième 16C modules de mesure, associés respectivement aux premier 14A, deuxième 14B et troisième 14C conducteurs électriques. Plus précisément, le système de détection 12 comprend un module de mesure 16A, 16B, 16C pour chaque conducteur électrique 14A, 14B, 14C. Le système de détection 12 comporte également une unité 18 d'acquisition de valeurs mesurées de la grandeur électrique.

La grandeur électrique acquise par le système de détection 12 est, par exemple, l'intensité d'un courant circulant dans chaque conducteur électrique 14A, 14B, 14C.

En variante, la grandeur électrique est une tension mesurée dans chaque conducteur. Dans cette variante, l'organe de détection 38A est, par exemple, propre à détecter un défaut électrique lorsque la valeur de la tension mesurée sur le conducteur électrique correspondant est supérieure à un premier seuil minimal de tension U1min et/ou inférieure à un premier seuil maximal U1max. Le premier seuil minimal de tension U1min est, par exemple, égal à 50% de la tension nominale, et le premier seul maximal de tension U1 max est, par exemple, égal à 150 % de la tension nominale.

Dans la suite de la description, seuls les éléments qui composent le premier module de mesure 16A seront décrits précisément, sachant que les éléments qui composent les autres modules de mesure 16B, 16C sont identiques aux éléments du premier module de mesure 16A et portent les mêmes références, en remplaçant chaque fois la lettre A par la lettre B, C correspondante.

Le premier module de mesure 16A comprend un capteur 22A de mesure du courant, un premier émetteur-récepteur radioélectrique 24A, une première antenne radioélectrique 26A, une première unité de traitement d'informations 28A, un convertisseur analogique numérique 30A et un premier organe 32A d'alimentation électrique de ces éléments.

Le premier module de mesure 16A comprend une première horloge 34A, définie par un premier instant initial I01A et une première fréquence d'horloge F1A et générée, par exemple, par une première unité 36A de génération d'horloge.

Plus généralement, la première horloge 34A définit un premier référentiel temporel associé au premier module de mesure 16A et permet d'associer à chaque action réalisée par le premier module 16A, un premier instant de réalisation auquel ladite action a été réalisée. Le premier instant de réalisation est déterminé par rapport au premier instant initial I01A et en fonction de la première horloge F1A, c'est-à-dire dans le premier référentiel temporel, ou suivant le premier référentiel temporel.

Le premier module de mesure 16A comprend également une unité d'horodatage 37A et un organe 38A de détection d'un défaut électrique associé au premier conducteur 14A.

Le défaut électrique est, par exemple, un défaut de type phase-terre et est, par exemple, dû à une branche d'arbre reliant l'un des conducteurs électriques 14A, 14B, 14C à la terre.

L'unité d'acquisition 18 comporte un deuxième émetteur-récepteur radioélectrique 40, une deuxième antenne radioélectrique 42, une unité 44 de stockage de données et d'horodatage et une deuxième unité de traitement d'informations 46.

L'unité d'acquisition 18 comporte d'une deuxième horloge 48 définie par un deuxième instant initial I02 et une deuxième fréquence d'horloge F2 et générée, par exemple, par une deuxième unité 50 de génération d'horloge.

Plus généralement, la deuxième horloge 48 définit un deuxième référentiel temporel associé à l'unité d'acquisition 18 et permet d'associer à chaque action réalisée par l'unité d'acquisition 18, un deuxième instant de réalisation auquel ladite action a été réalisée. Le deuxième instant de réalisation est déterminé par rapport au deuxième instant initial I02 et en fonction de la deuxième fréquence d'horloge F2, c'est-à-dire dans le deuxième référentiel temporel, ou suivant le deuxième référentiel temporel.

L'unité d'acquisition 18 comprend également un bloc de communication 54 et un deuxième organe 56 d'alimentation électrique des éléments qu'elle comprend.

Le capteur de courant 22A est propre à mesurer la valeur de l'intensité du courant associé au premier conducteur électrique 14A, c'est-à-dire parcourant le premier conducteur électrique 14A.

Le capteur de courant 22A est également apte, à partir de l'unité d'horodatage 37A, à associer à chaque valeur de l'intensité du courant qu'il mesure, un premier instant Im1A de mesure de ladite valeur, déterminé par rapport au premier instant initial I01A et en fonction de la première fréquence F1A, c'est-à-dire suivant le premier référentiel temporel.

Le premier émetteur-récepteur radioélectrique 24A est de préférence conforme au protocole de communication ZIGBEE ou ZIGBEE GREEN POWER basé sur la norme IEEE-802.15.4. En variante, le premier émetteur-récepteur radioélectrique 24A est conforme à la norme IEEE-802.15.1 ou à la norme IEEE-802.15.2. En variante encore, le premier émetteur-récepteur radioélectrique 24A est conforme à la norme IEEE-802-11. En variante encore, sans répondre à une norme IEEE, cet émetteur est conforme aux réglementations en vigueur dans chaque pays (solution de communication radio propriétaire).

La première antenne radioélectrique 26A est adaptée pour émettre des signaux radioélectriques à destination de la deuxième antenne 42 de l'unité d'acquisition 18. Autrement dit, chaque module de mesure 16A, 16B, 16C est relié à l'unité d'acquisition 18 par une liaison radioélectrique correspondante.

La première unité de traitement 28A comprend un premier processeur 60A et une première mémoire 62A.

En complément, le convertisseur analogique numérique 30A est propre à échantillonner, selon une fréquence d'échantillonnage $F_{ECH}$, les valeurs d'intensité mesurées par le capteur de courant 22A. Ainsi, le convertisseur analogique numérique 30A forme en outre un organe d'échantillonnage. Le convertisseur analogique numérique 30A est propre à associer, à partir de l'unité d'horodatage 37A, un numéro d'échantillon et son premier instant de mesure Im1A à chaque échantillon.

Le premier organe d'alimentation électrique 32A comporte, par exemple, un tore disposé autour du premier conducteur 14A et un enroulement agencé autour du deuxième tore. La circulation du courant dans le premier conducteur 14A est alors propre à engendrer un courant induit dans l'enroulement. Autrement dit, le premier module de mesure 16A est autoalimenté par le tore et l'enroulement, qui récupèrent l'énergie magnétique et forment un transformateur de courant.

L'unité d'horodatage 37A est adaptée pour déterminer un instant d'émission d'un message quelconque à destination de l'unité d'acquisition. L'instant d'émission est déterminé dans le premier référentiel temporel.

L'organe de détection 38A est propre à déterminer la valeur d'un instant de détection Id1A du défaut dans le premier référentiel temporel associé au module de mesure 16A. L'organe de détection 38A est, par exemple, propre à détecter un défaut lorsque la variation de l'intensité du courant mesurée par le capteur de courant 22A est supérieure à un premier seuil de variation d'intensité, par exemple égal à 1000A/s pendant par exemple 20ms.

Le deuxième émetteur-récepteur radioélectrique 40 et la deuxième antenne radioélectrique 42 sont identiques au premier émetteur-récepteur radioélectrique 24A et à la première antenne radioélectrique 26A et sont adaptés pour communiquer avec le premier émetteur-récepteur radioélectrique 24A et la première antenne radioélectrique 26A.

L'unité de stockage et d'horodatage 44 est adaptée pour horodater et stocker chaque donnée reçue par l'unité d'acquisition et pour associer à chaque donnée reçue un instant de réception de la donnée. En d'autres termes, l'unité de stockage et d'horodatage 44 est adaptée pour déterminer un instant de réception d'un message quelconque reçu par l'unité d'acquisition. L'instant de réception est déterminé dans le deuxième référentiel temporel.

La deuxième unité de traitement 46 comprend un deuxième processeur 66 et une deuxième mémoire 68.

Le bloc de communication 54 permet une communication de l'unité d'acquisition 18 avec un organe extérieur, non représenté, à l'aide d'une liaison de communication, de préférence standardisée, telle qu'une liaison de type GSM, Protocole ModBus Serial Line, ou ModBus TCP/IP. Le bloc de communication 54 est par exemple adapté pour communiquer avec une centrale, non représentée, de gestion de l'installation électrique 10 ou avec des dispositifs de coupure du courant, non représentés, associés aux conducteurs électriques 14A, 14B, 14C.

Le premier processeur 60A est adapté pour exécuter des logiciels compris dans la première mémoire 62A.

La première mémoire 62A comprend un logiciel 71A de génération d'un message cyclique MtA, un logiciel 72A de transmission du message cyclique à destination de l'unité d'acquisition 18, propre à émettre de manière répéter le message cyclique MtA, par exemple toutes les secondes et un logiciel 73A de calcul d'une durée de transmission DtA entre l'instant de détection Id1A et un instant d'émission IeA du message cyclique MtA.

Le message cyclique MtA comprend une première variable V1 relative à l'instant d'émission IeA du message cyclique dans le premier référentiel temporel et la durée de transmission DtA. Avantageusement, le message cyclique MtA comprend la valeur de l'instant de détection Id1A dans le premier référentiel temporel. Dans la suite de la description, la première variable est choisie égale à l'instant d'émission IeA.

La première mémoire 62A comprend également un logiciel 75A d'identification des échantillons mesurés, un logiciel 77A de génération d'un message d'acquisition MdA et un logiciel 78A de transmission du message d'acquisition à l'unité d'acquisition 18.

Le message d'acquisition MdA comprend des échantillons de l'intensité mesurée du courant et au moins une deuxième variable V2 relative au premier instant de mesure de l'un des échantillons.

Le deuxième processeur 66 est adapté pour exécuter des logiciels stockés dans la deuxième mémoire 68.

Dans la suite de la description, on considère une configuration dans laquelle le premier module de mesure 16A détecte un défaut électrique à confirmer, également dit supposé, et les autres modules de mesure 16B, 16C ne détecte pas de défaut. Cependant, la description reste valable quel que soit le module de mesure ayant détecté le défaut électrique supposé en adaptant les références.

Ainsi, les logiciels présentés ci-dessus sont propres à être mis en oeuvre suite à la détection d'un défaut électrique supposé par n'importe lequel des modules de mesure 16A, 16B, 16C.

La deuxième mémoire 68 comprend, pour chaque module de mesure 16A, 16B, 16C muni d'un organe de détection 38 A et pris individuellement, et donc pour le premier module 16A, les éléments suivants :

- un premier logiciel 82 de détermination de la valeur de l'instant de détection Id1B, Id1C dans chaque premier référentiel temporel des autres premiers modules 16B, 16C,

- un deuxième logiciel de détermination 84 propre à calculer la valeur de l'instant de détection Id2 dans le deuxième référentiel temporel,
- un logiciel 86 de définition d'un premier intervalle temporel prédéfini correspondant T1A, T1B, T1C pour chaque module de mesure 16A, 16B, 16C. Chaque premier intervalle correspondant T1A, T1B, T1C comprend la valeur de l'instant de détection Id1A, Id1B, Id1C déterminée par rapport au premier instant initial I01A, I01B, I01C et en fonction de la première fréquence F1A, F1B, F1C de la première horloge 34A, 34B, 34C du module de mesure 16A, 16B, 16C auquel il est associé,
- un premier logiciel 90 d'acquisition de chaque valeur mesurée par chaque module de mesure 16A, 16B, 16C et dont le premier instant de mesure Im1A, Im1B, Im1C est compris dans le premier intervalle correspondant T1A, T1B, T1C. En d'autres termes le premier logiciel d'acquisition 90 est apte à acquérir les seules valeurs mesurées pour lesquelles le premier instant de mesure est compris dans le premier intervalle correspondant T1A, T1B, T1C. Le premier logiciel d'acquisition 90 est propre à générer pour chaque module un message de sélection MselA, MselB, MselC correspondant qui comprend le premier intervalle T1A T1B, T1C correspondant.

De plus, la deuxième mémoire 68 comprend un deuxième logiciel 92 de détermination, pour chaque valeur acquise via le premier logiciel d'acquisition 90, d'un deuxième instant Im2A, Im2B, Im2C de mesure de ladite valeur, déterminé dans le deuxième référentiel.

La deuxième mémoire 68 comporte, en outre, un premier logiciel 94 de calcul d'une suite de troisièmes instants régulièrement espacés et déterminés par rapport au deuxième instant initial et en fonction de la deuxième fréquence, et un deuxième logiciel de calcul 96 propre à estimer, suivant une méthode de calcul prédéterminée, la valeur de chaque valeur d'intensité du courant mesurée par chaque capteur aux troisièmes instants, en fonction des valeurs acquises et des deuxièmes instants de mesure Im. La méthode de calcul est par exemple une interpolation linéaire, polynomiale ou cosinus. Les troisièmes instants sont compris autour de l'instant de détection déterminé dans le deuxième référentiel temporel, par exemple à moins de 200 ms de l'instant de détection

La deuxième mémoire 68 comporte, en outre, pour chaque module de mesure 16A, 16B, 16C, un troisième logiciel 97 de calcul d'un ratio correspondant RA(2), RB(2), RB(3) entre, d'une part, une première durée D1A, D1B, D1C écoulée entre deux instants d'émission IeA(1), IeA(2), IeB(1), IeB(2), IeC(1), IeC(2) successifs et, d'autre part, une deuxième durée D2A, D2B, D2C écoulée entre deux instants de réception IrA(1), IrA(2), IrB(1), IrB(2), IrC(1), IrC(2) successifs correspondants. Les instants de réception IrA(1), IrA(2), IrB(1), IrB(2), IrC(1), IrC(2) ont déterminés dans le deuxième référentiel temporel par l'unité de stockage 44.

On obtient ainsi : $RA(2) = \dfrac{IeA(2) - IeA(1)}{IrA(1) - IrA(2)}$ et les mêmes équations pour RB(2) et RC(2) en remplaçant la lettre A par les lettres B et C.

Dans la suite de la description, on considère le temps écoulé entre chaque instant d'émission IeA(1), IeA(2), IeB(1), IeB(2), IeC(1), IeC(2) et l'instant de réception correspondant IrA(1), IrA(2), IrB(1), IrB(2), IrC(1), IrC(2) comme négligeable et approximativement nul.

Enfin, la deuxième mémoire 68 comprend un logiciel 98 de confirmation adapté pour confirmer l'apparition du défaut électrique, en fonction des valeurs de courant acquises et des deuxièmes instants de mesure Im2A, Im2B, Im2C associés.

Avantageusement, la deuxième mémoire 68 comprend un logiciel de gestion de la communication 100 adapté pour transmettre périodiquement, par exemple toutes les secondes, un message de synchronisation Msyn à tous les modules de mesure 16A, 16B, 16C. Le message de synchronisation comprend, par exemple, pour chaque module de mesure 16A, 16B, 16C des bornes d'un intervalle temporel de communication PA, PB, PC, définissant une période temporel pendant laquelle chaque module de mesure est propre à transmettre le message cyclique MtA, MtB, MtC. L'intervalle temporel PA, PB, PC est différent pour chaque module de mesure 16A, 16B, 16C, afin d'éviter la collision des messages cycliques MtA, MtB, MtC et la perte d'informations. Chaque intervalle temporel est défini par rapport à un instant de réception, par le module de mesure 16A, 16B, 16C correspondant, du message de synchronisation Msyn et en fonction de la première fréquence F1A, F1B, F1C du module de mesure 16A, 16B, 16C.

Le logiciel de calcul de la durée de transmission 73A est propre à associer à chaque instant de détection Id1A, un instant d'émission IeA(2) suivant du message cyclique MtA(2), faisant suite à l'instant de détection Id1A. Le logiciel de calcul 73A est adapté pour fixer la durée de transmission DtA égale à la différence entre l'instant d'émission suivant IeA(2) et l'instant de détection Id1A.

Le logiciel d'identification 75A est, par exemple, propre à identifier les échantillons dont le premier instant de mesure appartient au premier intervalle T1A, T1B, T1C transmis via le message de sélection MselA, MselB, MselC correspondant. Chaque logiciel de génération 77A, 77B, 77C est alors adapté pour générer un message d'acquisition MdA(1), MdA(2), MdA(3) correspondant comprenant les échantillons identifiés et la deuxième variable V2.

Avantageusement, le logiciel d'identification 75A est par exemple propre à identifier un premier échantillon correspondant à l'échantillon identifié associé au plus petit premier instant de mesure Im1A, Im1B, Im1C et un dernier échantillon correspondant à l'échantillon identifié associé au plus grand premier instant de mesure Im1A, Im1B, Im1C. Le message d'acquisition correspondant comprend alors les premiers instants de mesure du premier échantillon et du dernier échantillon.

Le premier logiciel de détermination 82 est propre à calculer la valeur de l'instant de détection Id1A pour chacun des premiers référentiels temporels. Plus précisément, le premier logiciel de calcul 82 est propre à calculer pour chaque module de mesure 16A, 16B, 16C une troisième durée D3A, D3B, D3C entre, d'une part, l'instant de réception IrA(2), IrB(2), IrC(2), dans le deuxième référentiel temporel, d'un dernier message cyclique MtA(2), MtB(2), MtC(2) transmis par le module de mesure et, d'autre part, l'instant de détection Id2 calculé dans le deuxième référentiel temporel.

Le premier logiciel de calcul 82 est alors propre à déterminer, dans le premier référentiel temporel de chaque module de mesure 16A, 16B, 16C, la valeur de l'instant de détection Id1A, Id1B, Id1C en fonction de l'instant d'émission du dernier message cyclique émis IeA(2), IeB(2), IeC(2) par le module de mesure correspondant, du ratio correspondant RA(2), RB(2), RC(2) et de la troisième durée correspondante D3A, D3B, D3C. On obtient ainsi, par exemple, $IdB = IeB(2) - (D3B * RB(2))$ et $IdC = IeC(2) - (D3C * RC(2))$.

Le deuxième logiciel de détermination 84 est propre à calculer la valeur de l'instant de détection Id2 dans le deuxième référentiel temporel en fonction de la durée de transmission DtA, de la valeur de l'instant de réception IrA(2) et du ratio Ra(2) correspondants. On obtient ainsi, par exemple, $Id = IrA(2) - \dfrac{DtA}{Ra(2)}$.

Le logiciel de définition 86 est propre à déterminer, pour chaque premier module 16A, 16B, 16C, le premier intervalle correspondant T1A, T1B, T1C en fonction du ratio correspondant RA(2), RB(2), RC(2), d'une troisième durée correspondante D3A, D3B, D3C et du temps d'émission du dernier message cyclique correspondant IeA(2), IeB(2), IeC(2) dans le premier référentiel temporel. Chaque premier intervalle est prédéfini, par exemple selon les équations suivantes :

$$ \mathrm{T1A} = \big[\mathrm{IeA}(2) \text{ - } ((D3A + Cst2) * RA(2));\ \mathrm{IeA}(2) \text{ - } ((D3A - Cst1) * Ra(2))\big], $$

$$ \mathrm{T1B} = \big[\mathrm{IeB}(2) \text{ - } ((D3B + Cst2) * RB(2));\ \mathrm{IeB}(2) \text{ - } ((D3B - Cst1) * RB(2))\big], $$

$$ \mathrm{T1C} = \big[\mathrm{IeC}(2) \text{ - } ((D3C + Cst2) * RC(2));\ \mathrm{IeA}(2) \text{ - } ((D3C - Cst1) * RC(2))\big], $$

avec Cst1 et Cst2 des valeurs constantes.

Le deuxième logiciel de détermination 92 est propre à calculer le deuxième instant de mesure Im2A, Im2B, Im2C de chaque valeur acquise en fonction de la deuxième variable V2 correspondante transmise. Avantageusement, le deuxième logiciel de calcul 92 est propre à calculer le deuxième instant de mesure Im2A, Im2B, Im2C de chaque valeur acquise, en fonction des premiers instants de mesure Im1A, Im1B, Im1C, du premier échantillon et du dernier échantillon transmis.

Plus précisément, le deuxième logiciel de détermination 92 est, par exemple, propre à recevoir l'instant d'émission du message d'acquisition et à déterminer l'instant de réception du message d'acquisition, puis à calculer en fonction de l'instant d'émission, du premier instant de mesure du premier échantillon, de l'instant de réception et du ratio correspondant la valeur du deuxième instant de mesure du premier échantillon. Le deuxième logiciel de détermination 92 est alors propre à déterminer également la valeur du deuxième instant de mesure du dernier échantillon de manière similaire et à déterminer le deuxième instant de mesure de chaque échantillon en fonction du nombre d'échantillons acquis, du ratio correspondant et des deuxièmes instants de mesure du premier et du dernier échantillon.

Par exemple, le deuxième logiciel de détermination 92 définit un peigne d'échantillonnage sur une partie commune à tous les signaux reçus de la part des capteurs. Une suite de dates est associée au peigne d'échantillonnage dans le deuxième référentiel temporel, et cette suite de dates est convertie dans le premier référentiel temporel de chaque module de mesure 16A, 16B, 16C.

Pour un signal donné, chacune de ces dates converties est encadrée par deux dates d'échantillonnage dans le premier référentiel temporel.

Les trois dates et les deux valeurs d'échantillons permettent d'appliquer une interpolation linéaire.

D'autres principes d'interpolation sont bien entendu possibles, en prenant au besoin davantage de points en avant et en arrière du point de chacune des dates converties.

Le premier logiciel de calcul 94 est, par exemple, propre à calculer les troisièmes instants en fonction de la valeur de l'instant de détection dans le deuxième référentiel temporel. Les troisièmes instants sont compris dans un intervalle de référence Tref dont une borne minimale est par exemple égale à l'instant de détection Id2 dans le deuxième référentiel, auquel on a soustrait une valeur égale à la constante Cst2 et dont une borne maximale est par exemple égale à l'instant de détection Id2 dans le deuxième référentiel, auquel on a ajouté une valeur égale à la constante Cst1.

Le logiciel de confirmation 98 est par exemple propre à sommer les valeurs d'intensité estimées pour un même troisième instant. Plus précisément, lorsque la somme est supérieure à un deuxième seuil de courant A2 l'apparition du défaut électrique est confirmée. Le deuxième seuil de courant A2 est, par exemple, égal à 30 A.

Avantageusement encore, l'unité d'acquisition 18 est propre à transmettre à chaque module de mesure 16A, 16B, 16C un message d'indication MindicA, MindicB, MindicC, indiquant que le message d'acquisition MdA(1), MdA(2), MdA(3) transmis par le module de mesure 16A, 16B, 16C a bien été reçu.

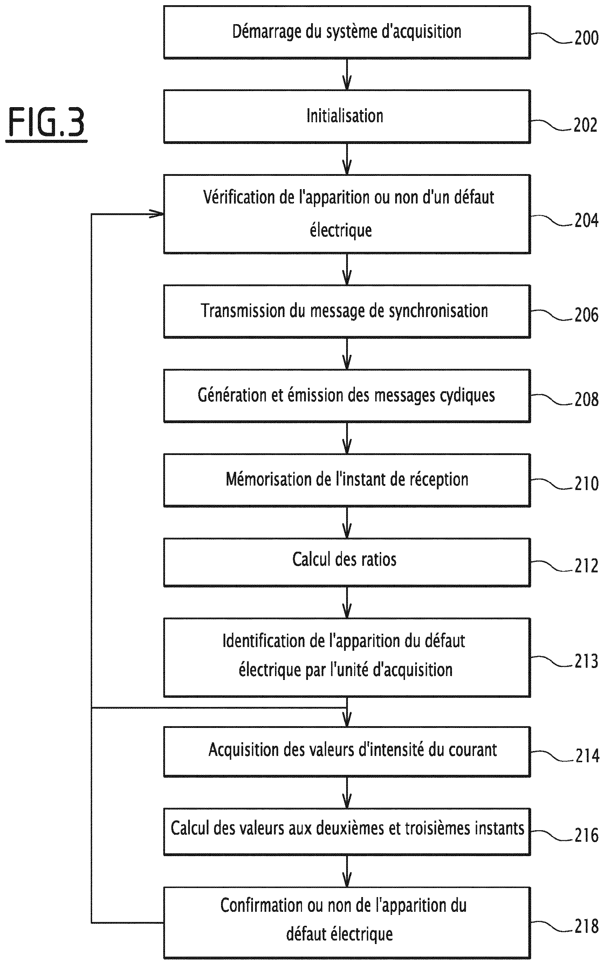

Un exemple d'un procédé de détection d'un défaut électrique conforme à l'invention est présenté à la figure 3. Un tel procédé est mis en oeuvre par le système de détection 12 décrit ci-dessus.

Le procédé de détection est présenté dans le cadre de la détection d'un défaut électrique supposé au niveau du premier module de mesure 16A.

Au cours d'une première étape 200 de démarrage du système de détection 12, chaque module de mesure 16A, 16B, 16C est mis sous tension, de même que l'unité d'acquisition 18. Les modules de mesure 16A, 16B, 16C démarrent respectivement aux premiers instants initiaux I01A, I01B, I01C et l'unité d'acquisition 18 démarre au deuxième instant initial I02.

Puis, lors d'une étape suivante 202 d'initialisation, l'unité d'acquisition 18 transmet le message de synchronisation Msyn à chaque module de mesure 16A, 16B, 16C. Chaque module de mesure 16A, 16B, 16C reçoit donc les valeurs des bornes de l'intervalle de communication PA, PB, PC. Ensuite, chaque module de mesure 16A, 16B, 16C transmet le message cyclique MtA(1), MtB(1), MtC(1), qu'il a généré via son logiciel de génération 71A, 71B, 71C. Chaque message cyclique MtA(1), MtB(1), MtC(1) est émis en fonction des bornes de l'intervalle de communication PA, PB, PC reçues par le module de mesure 16A, 16B, 16C et du premier référentiel temporel associé au module de mesure 16A, 16B, 16C qui l'émet. En d'autres termes, dans le cas du premier module de mesure 16A, le premier module de mesure 16A compte par exemple un nombre de périodes de la première horloge 34A apparues depuis la réception du message de synchronisation Msyn et lorsque le nombre apparu correspond à un temps égal à une borne inférieure de l'intervalle de communication PA, il émet le message cyclique MtA. La durée de transmission comprise dans les messages cycliques MtA(1), MtB(1), MtC(1) a une valeur indiquant qu'aucun défaut n'a été détecté. Avantageusement, le message cyclique MtA(1), MtB(1), MtC(1) comprend une troisième variable V3A, V3B, V3C ayant une valeur indiquant la non-détection du défaut électrique.

Ensuite, toujours au cours de l'étape d'initialisation 202, l'unité d'acquisition 18 mémorise la valeur de l'instant de réception IrA(1), IrB(1), IrC(1) de chaque message cyclique MtA(1), MtB(1), MtC(1) émis par chaque module de mesure 16A, 16B, 16C.

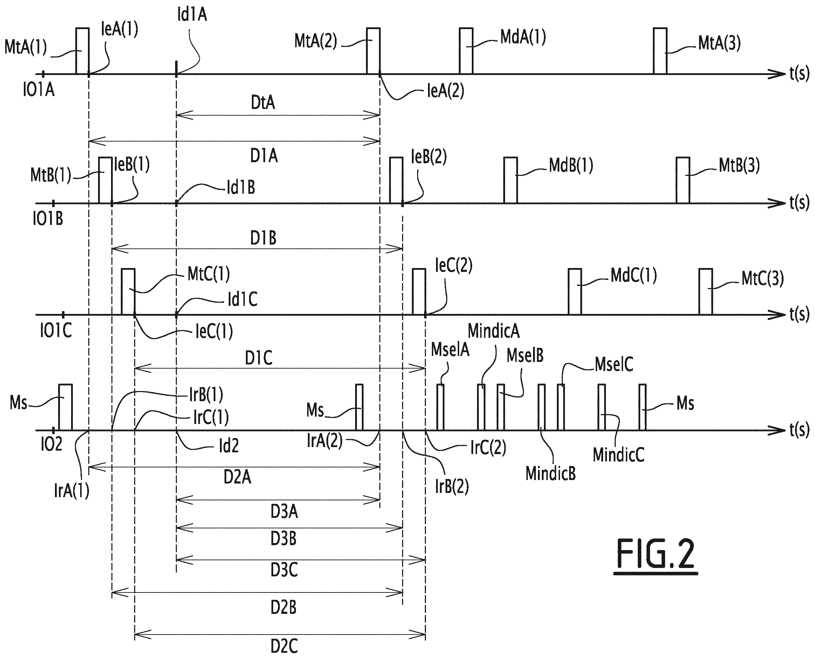

Puis, au cours d'une étape de vérification 204, chaque module de mesure 16A, 16B, 16C conforme ou non à l'apparition du défaut électrique supposé au niveau du conducteur électrique 14A, 14B, 14C auquel il est associé. En référence à la figure 2, et dans l'exemple considéré, l'organe de détection 38A détecte le défaut électrique supposé au cours de l'étape de vérification 204 et détermine la valeur de l'instant de détection dans le premier référentiel.

Ensuite, au cours d'une étape de synchronisation 206, l'unité d'acquisition 18 transmet le message de synchronisation Msyn à chaque module de mesure 16A, 16B, 16C.

Lors d'une étape de génération 208, chaque module de mesure 16A, 16B, 16C génère le message cyclique correspondant MtA(2), MtB(2), MtC(2). La troisième variable V3A comprise dans le message cyclique MtA(2) a une valeur indiquant l'apparition du défaut électrique supposé, tandis que dans les messages cycliques MtB(2), MtC(2), la troisième variable V3B, V3C a une valeur relative à la non-détection du défaut électrique supposé. Puis, chaque module de mesure 16A, 16B, 16C émet le message cyclique MtA(2), MtB(2), MtC(2) qu'il a généré en direction de l'unité d'acquisition 18.

Ensuite, lors d'une étape 210 de vérification, l'unité d'acquisition 18 mémorise la valeur de l'instant de réception de chaque message cyclique MtA(2), MtB(2), MtC(2).

Lors d'une étape de calcul 212, l'unité d'acquisition 18 calcule les premières D1A, D1B, D1C et deuxièmes D2A, D2B, D2C durées, à partir desquelles elle calcule les ratios RA(2), RB(2), RC(2) associés à chaque module de mesure 16A, 16B, 16C.

Puis, au cours d'une étape d'identification 213, l'unité d'acquisition 18 identifie si l'un des modules de mesure a détecté ou non le défaut électrique. Dans cet exemple, l'unité d'acquisition identifie par exemple, via les troisièmes variables, l'apparition du défaut électrique supposé sur le premier conducteur 14A et la non-détection du défaut électrique sur les autres conducteurs 14B, 14C.

Si l'apparition d'aucun défaut n'a été identifiée par les modules de mesures, au cours de l'étape d'identification 213, alors le procédé retourne à l'étape de vérification 204.

Autrement, pour chaque module de mesure 16A, 16B, 16C ayant détecté le défaut électrique, le procédé comprend les étapes présentées ci-dessous.

Au cours d'une étape 214 d'acquisition des valeurs d'intensité du courant, l'unité d'acquisition 18 calcule la valeur de l'instant de détection Id2, Id1A, Id1B, Id1C dans le deuxième référentiel et dans chaque premier référentiel, les troisièmes durées D3A, D3B, D3C et détermine le premier intervalle temporel prédéfini T1A, T1B, T1C pour chaque premier module 16A, 16B, 16C. Ensuite, l'unité d'acquisition génère les messages de sélection MselA, MselB, MselC, et chaque message de sélection MselA, MselB, MselC est transmis successivement. Plus précisément, suite à la transmission d'un message de sélection MselA, MselB, MselC, on attend la réception du message d'acquisition MdA(1), MdB(1), MdC(1) correspondant avant de transmettre un autre message de sélection. Suite à la réception du message de sélection qui lui est destiné, chaque module de mesure 16A, 16B, 16C génère le message d'acquisition MdA(1), MdA(2), MdA(3) correspondant et le transmet à l'unité d'acquisition 18. Avantageusement, suite à la réception du message d'acquisition, l'unité d'acquisition 18 transmet au module de mesure correspondant le message d'indication MindicA, MindicB, MindicC, indiquant au module de mesure 16A, 16B, 16C que le message d'acquisition transmis par le module de mesure 16A, 16B, 16C a bien été reçu.

Puis, suite à la réception de tous les messages d'acquisition, lors d'une étape de calcul 216, l'unité d'acquisition 18 calcule les deuxièmes instants de mesure Im2A, Im2B, Im2C des valeurs ou échantillons acquis, puis détermine la suite de troisièmes instants et la valeur de l'intensité du courant mesurée par chaque capteur aux troisièmes instants.

Enfin, lors d'une étape de confirmation 218, l'unité d'acquisition somme les valeurs d'intensité du courant déterminées pour chaque même troisième instant, et confirme ou non la détection de l'apparition du défaut électrique. Plus précisément, si la somme des valeurs d'intensité du courant mesurées est supérieure au deuxième seuil de courant A2 alors le défaut est confirmé et, dans le cas contraire la détection du défaut est infirmée.

Suite à l'étape 218, l'étape 204 de vérification est, par exemple, répétée avec une périodicité de 1 seconde.

Avantageusement, si le même procédé est utilisé pour récupérer également les valeurs de tension mesurées sur chaque conducteur électrique 14A, 14B, 14C, le logiciel de confirmation est apte à identifier, en fonction du déphasage des tensions et courants estimés pour un même troisième instant, la localisation amont ou aval du défaut électrique par rapport aux modules de mesure et relativement à la source. Dans cette variante, les modules de mesure mesurent le courant et la tension, et l'apparition du défaut électrique est confirmée en fonction des valeurs de courant et/ou tension. Le logiciel de confirmation est, par exemple, propre à sommer les valeurs de tension estimées pour un même troisième instant. Plus précisément, lorsque la somme des tensions estimées est supérieure à un deuxième seuil de tension U2 et/ou lorsque la somme des intensités du courant estimées est supérieure au deuxième seuil de courant A2, l'apparition du défaut électrique est confirmée. Le deuxième seuil de tension U2 est, par exemple, égal à 10kV.

Avantageusement, l'unité d'acquisition comprend une lampe adaptée pour s'éclairer de différentes couleurs suivant la confirmation ou non de l'apparition du défaut électrique.

Le système de détection 12 permet d'obtenir la valeur de l'instant de détection Id1A dans chaque premier référentiel et dans le deuxième référentiel, et ainsi d'identifier précisément les valeurs mesurées par chaque module de mesure au moment de l'instant de détection. Ceci permet de prendre en compte les différences de valeurs entre chaque premier instant initial et le deuxième instant initial, et entre chaque première fréquence d'horloge et la deuxième fréquence d'horloge.

Le système de détection permet ainsi d'acquérir, pour chaque module de mesure, les valeurs mesurées autour d'un même instant absolu correspondant à la détection du défaut électrique supposé. Les valeurs acquises par l'unité d'acquisition pour chaque module de mesure ont donc été mesurées globalement au même instant et au moment de l'apparition du défaut électrique supposé, ce qui permet de faciliter et d'améliorer la confirmation de la détection du défaut électrique à partir de ces valeurs.

En outre, le système de détection 12 permet de diminuer la quantité d'informations échangées entre les modules de mesure et l'unité d'acquisition puisque l'unité d'acquisition 18 récupère seulement les valeurs mesurées ayant un premier instant de mesure compris dans les premiers intervalles.

De plus, le système de détection 12 permet d'obtenir les valeurs mesurées par chaque module de mesure 16A, 16B, 16C, autour de l'instant de détection, dans un même référentiel temporel qui est le deuxième référentiel temporel. Cela permet de vérifier précisément les écarts temporels entre les instants de mesure des différentes valeurs mesurées et notamment d'estimer, c'est-à-dire d'extrapoler, la valeur du courant circulant sur chaque conducteur à un même instant grâce au premier logiciel de calcul 94.

Finalement, le système permet d'obtenir des valeurs du courant et/ou de la tension sur chaque conducteur électrique 14A, 14B, 14C, au moment de l'apparition d'un défaut électrique supposé, synchronisées, c'est-à-dire obtenues au même instant, et ainsi de confirmer ou non l'apparition du défaut électrique.

En variante, certains modules de mesure 16A, 16B, 16C ne comprennent pas d'organe de détection.

Selon une autre variante, l'unité d'acquisition 18 est intégrée dans l'un des modules de mesure 16A, 16B, 16C et la deuxième horloge est identique à la première horloge du module de mesure dans lequel l'unité d'acquisition est intégrée. Le fonctionnement est alors sensiblement identique à ce qui a été présenté ci-dessus mise à part le fait que l'unité d'acquisition ne communique pas en radio mais en filaire avec le module de mesure dans lequel elle est intégrée. Dans cette variante, les valeurs mesurées par chaque module de mesure 16A, 16B, 16C, autour de l'instant de détection, sont obtenues dans un même référentiel temporel, qui est le premier référentiel temporel associé au module de mesure comprenant l'unité d'acquisition.

Selon une autre variante, la première mémoire 62A comprend un logiciel d'identification des numéros des échantillons dont le premier instant de mesure appartient au premier intervalle transmis via le message de sélection MselA, MselB, MselC correspondant, et un logiciel d'émission adapté pour émettre à destination de l'unité d'acquisition 18 un message d'identification comprenant les numéros d'échantillons identifiés. L'unité d'acquisition est alors propre à transmettre à chaque module de mesure 16A, 16B, 16C un message de demande des numéros d'échantillons qu'elle a reçu en provenance du module correspondant et chaque module de mesure 16A, 16B, 16C envoie en réponse le message d'acquisition correspondant MdA, MdB, MdC à destination de l'unité d'acquisition 18. Dans cette variante, le message d'acquisition MdA, MdB, MdC comprend tous les échantillons demandés via le message de demande.

## Revendications

1. Système de détection (12) d'un défaut électrique dans une installation électrique comprenant plusieurs conducteurs électriques (14A, 14B, 14C), le système comprenant :

   - au moins deux modules de mesure (16A, 16B, 16C), chaque module de mesure (16A, 16B, 16C) comportant des premiers moyens radioélectriques de communication (24A, 26A, 24B, 26B, 24C, 26C), un capteur (22A, 22B, 22C) de mesure de chaque grandeur électrique associée à un conducteur électrique (14A, 14B, 14C) correspondant et une première horloge (34A, 34B, 34C) définie par un premier instant initial (I01A, I01B, I01C) et une première fréquence d'horloge (F1A, F1B, F1C), chaque valeur mesurée étant propre à être associée à un premier instant de mesure (Im1A, Im1B, Im1C), déterminé par rapport au premier instant initial (I01A, I01B, I01C) et en fonction de la première fréquence (F1A, F1B, F1C),
   - une unité d'acquisition (18) des valeurs mesurées, comportant des deuxièmes moyens radioélectriques (40, 42) adaptés pour communiquer avec les premiers moyens radioélectriques de communication (24A, 26A, 24B, 26B, 24C, 26C),

   **caractérisé en ce que** le système comprend, pour au moins l'un des modules de mesure (16A), un organe (38A) de détection du défaut électrique associé au conducteur électrique correspondant (14A), l'organe de détection (38A) étant propre à déterminer la valeur d'un instant de détection (Id1A) du défaut par rapport au premier instant initial et en fonction de la première fréquence,
   **en ce que**, l'unité d'acquisition comprend :

   - des premiers moyens (82) de détermination de la valeur de chaque instant de détection par rapport au premier instant initial (I01B, I01C) et en fonction de la première fréquence (F1 B, F1 C) des autres modules de mesure (16A, 16B, 16C),
   - des moyens d'acquisition (90) pour chaque module de mesure des seules valeurs mesurées pour lesquelles le premier instant de mesure (Im1A, Im1B, Im1C) est compris dans un premier intervalle temporel prédéfini correspondant (T1A, T1B, T1C), chaque premier intervalle correspondant (T1A, T1B, T1C) comprenant la valeur de l'instant de détection (Id1A, Id1B, Id1C) déterminée pour ledit module de mesure auquel il est associé.

2. Système selon la revendication 1, dans lequel l'unité d'acquisition (18) comporte une deuxième horloge (48) définie par un deuxième instant initial (I02) et une deuxième fréquence d'horloge (F2), et dans lequel les premiers moyens de détermination (82) sont propres à déterminer la valeur de l'instant de détection, par rapport au deuxième instant initial (102) et en fonction de la deuxième fréquence (F2).

3. Système selon la revendication 1 ou 2, dans lequel l'unité d'acquisition comporte une deuxième horloge (48) définie par un deuxième instant initial (I02) et une deuxième fréquence d'horloge (F2), et dans lequel l'unité d'acquisition comprend des deuxièmes moyens (84) de détermination, pour chaque valeur acquise, d'un deuxième instant (Im2A, Im2B, Im2C) de mesure de ladite valeur, déterminé par rapport au deuxième instant initial (I02) et en fonction de la deuxième fréquence (F2).

4. Système selon la revendication 3, dans lequel l'unité d'acquisition (18) comprend des premiers moyens (94) de calcul propres à calculer une suite de troisièmes instants régulièrement espacés et déterminés par rapport au deuxième instant initial (I02) et en fonction de la deuxième fréquence (F2), et des deuxièmes moyens de calcul (96) propres à estimer la valeur de chaque grandeur électrique mesurée, aux troisièmes instants et en fonction des valeurs acquises et des deuxièmes instants de mesure (Im2A, Im2B, Im2C).

5. Système selon l'une quelconque des revendications précédentes, dans lequel la ou les grandeurs électriques sont choisies parmi une tension et un courant.

6. Système selon la revendication 3 ou 4 et selon la revendication 5, dans lequel l'unité d'acquisition (18) comprend des moyens de confirmation (98) adaptés pour confirmer l'apparition du défaut électrique en fonction des valeurs acquises et des deuxième instants de mesure associés (Im2A, Im2B, Im2C).

7. Système selon l'une quelconque des revendications 2 à 6, dans lequel chaque module de mesure comprend des moyens de génération (71A, 71B, 71C) d'un message cyclique (MtA(1), MtA(2), MtB(1), MtB(2), MtC(1), MtC(2)), comportant une première variable (V1 A, V1B, V1C) fonction d'un instant d'émission du message cyclique (IeA(1), IeA(2), IeB(1), IeB(2), IeC(1), IeC(2)) par rapport au premier instant initial (I01A, I01B, I01C) et selon la première fréquence (F1A, F1B, F1C), et des moyens de transmission (72A, 72B, 72C) du message cyclique à destination de l'unité d'acquisition (MtA(1), MtA(2), MtB(1), MtB(2), MtC(1), MtC(2)), dans lequel l'unité d'acquisition (18) est propre à déterminer un instant de réception du message cyclique (IrA(1), IrA(2), IrB(1), IrB(2), IrC(1), IrC(2)), par rapport au deuxième instant initial (I02) et en fonction de la deuxième fréquence (F2), et dans lequel pour chaque module de mesure (16A, 16B, 16C), l'unité d'acquisition (18) comprend des troisièmes moyens (97) de calcul d'un ratio (Ra(2), RB(2), RC(2)) entre, d'une part, une première durée (D1A, D1B, D1C) entre deux instants d'émission successifs (IeA(1), IeA(2), IeB(1), IeB(2), IeC(1), IeC(2)) et, d'autre part, une deuxième durée (D2A, D2B, D2C) entre deux instants de réception correspondants (IrA(1), IrA(2), IrB(1), IrB(2), IrC(1), IrC(2)).

8. Système selon la revendication précédente, dans lequel chaque module de mesure (16A) muni d'un organe de détection (38A) comprend des quatrièmes moyens (73A) de calcul d'une durée de transmission (DtA), les quatrièmes moyens de calcul (73A) étant propres à associer à chaque instant de détection (Id1A) un instant d'émission suivant (IeA(2)), après l'instant de détection, et à calculer la durée de transmission (DtA) entre l'instant de détection et l'instant d'émission suivant, le message cyclique (MtA(2)) comprenant la durée de transmission (DtA).

9. Système selon la revendication précédente, dans lequel les premiers moyens de détermination (82) sont propres à calculer, par rapport au deuxième instant initial (I02) et en fonction de la deuxième fréquence (F2), la valeur de l'instant de détection (Id2) en fonction de la durée de transmission (DtA), de la valeur de l'instant de réception (IrA(2)) et du ratio (RA(2)).

10. Système selon l'une quelconque des revendications 7 à 10, dans lequel les premiers moyens de détermination (82) sont propres à calculer, pour chaque module de mesure (16A, 16B, 16C), une troisième durée (D3A, D3B, D3C) entre l'instant de réception d'un dernier message cyclique (MtA(2), MtB(2), MtC(2)) transmis par le module de mesure et l'instant de détection (Id2) calculé par rapport au deuxième instant initial (I02) et en fonction de la deuxième fréquence (F2), et à déterminer, par rapport au premier instant initial et à la première fréquence (F1A, F1B, F1C) de chaque module de mesure (16A, 16B, 16C), la valeur de l'instant de détection (Id1B, Id1C) en fonction de l'instant d'émission (IeA(2), IeB(2), IeC(2)) du dernier message cyclique, du ratio correspondant (RA(2), RB(2), RC(2)) et de la troisième durée correspondante (D3A, D3B, D3C).

11. Système selon la revendication précédentes, dans lequel l'unité d'acquisition (18) comprend, pour chaque module de mesure (16A, 16B, 16C), des moyens (86) de définition du premier intervalle prédéfini correspondant (T1A, T1B, T1C) en fonction du ratio correspondant (RA(2), RB(2), RC(2)), d'une troisième durée correspondante (D3A, D3B, D3C) et du temps d'émission (IeA(2), IeB(2), IeC(2)) d'un dernier message cyclique par rapport au premier instant initial (I01A, I01B, I01C) et en fonction de la première fréquence (F1 A, F1B, F1C).

12. Système selon l'une quelconque des revendication précédentes, dans lequel chaque module de mesure comprend un organe d'échantillonnage (30A, 30B, 30C) propre à échantillonner les valeurs mesurées de chaque grandeur électrique selon une fréquence d'échantillonnage ($F_{ECH}$), un numéro d'échantillon et le premier instant de mesure (Im1A, Im1B, Im1C) correspondant étant associé à chaque échantillon,

dans lequel les moyens d'acquisition (90) sont propres à transmettre à chaque module de mesure, via un message de sélection (MselA, MselB, MselC), le premier intervalle correspondant, et

dans lequel chaque module de mesure est propre à transmettre à l'unité d'acquisition, via un message d'acquisition (MdA(1), MdB(1), MdC(1)), les échantillons dont le premier instant est compris dans le premier intervalle correspondant reçu et au moins une deuxième variable (V2A, V2B, V2C) relative au premier instant de mesure de l'un des échantillons.

13. Procédé de détection d'un défaut électrique dans une installation électrique comprenant plusieurs conducteurs électriques (14A, 14B, 14C), le procédé étant mis en oeuvre à l'aide d'un système de détection du défaut électrique comportant :

- au moins deux modules de mesure (16A, 16B, 16C), chaque module de mesure (16A, 16B, 16C) comportant des premiers moyens radioélectriques de communication (24A, 26A, 24B, 26B, 24C, 26C), un capteur (22A, 22B, 22C) de mesure de chaque grandeur électrique associée à un conducteur électrique (14A, 14B, 14C) correspondant et une première horloge (34A, 34B, 34C) définie par un premier instant initial (I01A, I01B, I01C) et une première fréquence d'horloge (F1A, F1B, F1C), chaque valeur mesurée étant propre à être associée à un premier instant de mesure (Im1A, Im1B, Im1C) déterminé par rapport au premier instant initial (I01A, I01B, I01C) et en fonction de la première fréquence (F1A, F1B, F1C),
- une unité d'acquisition (18) des valeurs mesurées, comportant des deuxièmes moyens radioélectriques de communication (40, 42) adaptés pour communiquer avec les premiers moyens radioélectriques (24A, 26A, 24B, 26B, 24C, 26C),

caractérisé en ce que le procédé comprend, pour au moins l'un des modules de mesure, les étapes suivantes

- a) la détection (204) du défaut électrique sur le conducteur électrique correspondant,
- b) la détermination (204) de la valeur d'un instant de détection du défaut par rapport au premier instant initial et en fonction de la première fréquence,

et en ce que le procédé comprend les étapes suivantes :

- c) la détermination (214) par l'unité d'acquisition de la valeur de chaque instant de détection par rapport au premier instant initial (I01B, I01C) et en fonction de la première fréquence (F1 B, F1 C) des autres modules de mesure,
- d) l'acquisition (214), par l'unité d'acquisition et pour chaque module de mesure, des seules valeurs mesurées pour lesquelles le premier instant de mesure est compris dans un premier intervalle temporel prédéfini (T1A, T1B, T1C) correspondant, chaque premier intervalle correspondant comprenant la valeur de l'instant de détection déterminée pour ledit module de mesure.

14. Procédé selon la revendication 13, dans lequel l'unité d'acquisition (18) comporte une deuxième horloge (48) définie par un deuxième instant initial et une deuxième fréquence d'horloge, et dans lequel, lors de l'étape d'acquisition d) le procédé comprend l'étape suivante :

- e) le calcul (216), pour chaque valeur acquise, d'un deuxième instant (Im2A, Im2B, Im2C) de mesure de la valeur, déterminé par rapport au deuxième instant initial (I02) et en fonction de la deuxième fréquence (F2).

15. Procédé selon l'une quelconque des revendications précédentes, dans lequel, précédemment à l'étape de détermination b), le procédé comprend une étape d1) d'identification (213), au cours de laquelle l'unité d'acquisition (18) vérifie si l'un des modules de mesure a détecté ou non le défaut électrique, et dans lequel les étapes de détermination c), et d'acquisition d) sont réalisées seulement si l'apparition du défaut électrique est identifiée lors de l'étape d'identification.

**Patentansprüche**

1. System (12) zum Detektieren eines elektrischen Fehlers in einer elektrischen Anlage, die mehrere elektrische Leitungen (14A, 14B, 14C) umfasst, wobei das System umfasst:

- mindestens zwei Messmodule (16A, 16B, 16C), wobei jedes Messmodul (16A, 16B, 16C) erste Funkkommunikationsmittel (24A, 26A, 24B, 26B, 24C, 26C), einen Sensor (22A, 22B, 22C) zum Messen jeder elektrischen Größe, die einer entsprechenden elektrischen Leitung (14A, 14B, 14C) zugeordnet ist, und eine erste Uhr (34A, 34B, 34C) aufweist, die durch einen ersten Anfangszeitpunkt (I01A, I01B, I01C) und eine erste Uhrfrequenz (F1A, F1B, F1C) definiert ist, wobei jeder gemessene Wert geeignet ist, einem ersten Messzeitpunkt (Im1A, Im1B, Im1C) zugeordnet zu werden, der in Bezug auf den ersten Anfangszeitpunkt (I01A, I01B, I01C) und abhängig von der ersten Frequenz (F1A, F1B, F1C) bestimmt ist,
- eine Einheit (18) zum Beschaffen von gemessenen Werten, die zweite Funkmittel (40, 42) aufweist, die geeignet sind, mit den ersten Funkkommunikationsmitteln (24A, 26A, 24B, 26B, 24C, 26C) zu kommunizieren,

**dadurch gekennzeichnet, dass** das System für mindestens eines der Messmodule (16A) ein Element (38A) zum Detektieren eines elektrischen Fehlers umfasst, der einer entsprechenden Leitung (14A) zugeordnet ist, wobei das Detektionselement (38A) geeignet ist, den Wert eines Detektionszeitpunkts (Id1A) des Fehlers in Bezug auf den ersten Ausgangszeitpunkt und abhängig von der ersten Frequenz zu bestimmen,
dass die Beschaffungseinheit umfasst:

- erste Mittel (82) zum Bestimmen des Werts jedes Detektionszeitpunkts in Bezug auf den ersten Ausgangszeitpunkt (I01B, I01C) und abhängig von der ersten Frequenz (F1B, F1C) der anderen Messmodule (16A, 16B, 16C),
- Mittel (90) zum Beschaffen von einzelnen gemessenen Werten für jedes Messmodul, für die der erste Messzeitpunkt (Im1A, Im1B, Im1C) in einem ersten vorbestimmten entsprechenden Messintervall (T1A, T1B, T1C) umfasst ist, wobei jedes erste entsprechende Intervall (T1A, T1B, T1C) den Wert des Detektionszeitpunkts (Id1A, Id1B, Id1C) umfasst, der für das Messmodul bestimmt ist, dem es zugeordnet ist.

2. System nach Anspruch 1, bei dem die Beschaffungseinheit (18) eine zweite Uhr (48) umfasst, die durch einen zweiten Ausgangszeitpunkt (102) und eine zweite Uhrfrequenz (F2) definiert ist, und bei dem die ersten Bestimmungsmittel (82) geeignet sind, den Wert des Detektionszeitpunkts in Bezug auf den zweiten Ausgangszeitpunkt (102) und abhängig von der zweiten Frequenz (F2) zu bestimmen.

3. System nach Anspruch 1 oder 2, bei dem die Beschaffungseinheit eine zweite Uhr (48) aufweist, die durch einen zweiten Ausgangszeitpunkt (102) und eine zweite Uhrfrequenz (F2) definiert ist, und bei dem die Beschaffungseinheit zweite Mittel (84) zum Bestimmen für jeden beschafften Wert eines zweiten Messzeitpunkts (Im2A, Im2B, Im2C) des Werts, der in Bezug auf den zweiten Ausgangszeitpunkt (102) und abhängig von der zweiten Frequenz (F2) bestimmt ist, umfasst.

4. System nach Anspruch 3, bei dem die Beschaffungseinheit (18) erste Berechnungsmittel (94), die geeignet sind, eine Folge von dritten Zeitpunkten zu berechnen, die gleichmäßig beabstandet sind und in Bezug auf den zweiten Ausgangszeitpunkt (102) und abhängig von der zweiten Frequenz (F2) bestimmt sind, und zweite Berechnungsmittel (96) umfasst, die geeignet sind, den Wert jeder gemessenen elektrischen Größe bei den dritten Zeitpunkten und abhängig von den beschafften Werten und den zweiten Messzeitpunkten (Im2A, Im2B, Im2C) zu schätzen.

5. System nach einem beliebigen der vorhergehenden Ansprüche, bei dem die elektrische(n) Größe(n) ausgewählt ist (sind) aus einer Spannung und einem Strom.

6. System nach Anspruch 3 oder 4 und nach Anspruch 5, bei dem die Beschaffungseinheit (18) Bestätigungsmittel (98) umfasst, die angepasst sind, das Auftauchen des elektrischen Fehlers abhängig von den beschafften Werten und den zweiten zugeordneten Messzeitpunkten (Im2A, Im2B, Im2C) zu bestätigen.

7. System nach einem beliebigen der Ansprüche 2 bis 6, bei dem jedes Messmodul Mittel (71A, 71B, 71C) zur Erzeugung einer zyklischen Nachricht (MtA(1), MtA(2), MtB(1), MtB(2), MtC(1), MtC(2)), die eine erste Variable (V1A, V1B, V1C) als Funktion eines Aussendezeitpunkts der zyklischen Nachricht (IeA(1), IeA(2), IeB(1), IeB(2), IeC(1), IeC(2)) in Bezug auf den ersten Ausgangszeitpunkt (I01A, I01B, I01C) und gemäß der ersten Frequenz (F1A, F1B, F1C) aufweist, und Mittel (72A, 72B, 72C) zur Übertragung der zyklischen Nachricht an die Beschaffungseinheit (MtA(1), MtA(2), MtB(1), MtB(2), MtzC(1), MtC(2)) umfasst, wobei die Beschaffungseinheit (18) geeignet ist, einen Empfangszeitpunkt der zyklischen Nachricht (IrA(1), IrA(2), IrB(1), IrB(2), IrC(1), IrC(2)) in Bezug den zweiten Ausgangszeitpunkt (102) und abhängig von der zweiten Frequenz (F2) zu bestimmen, und wobei für jedes Messmodul (16A, 16B, 16C) die Beschaffungseinheit (18) dritte Mittel (97) zur Berechnung eines Verhältnisses (Ra(2), RB(2), RC(2)) zwischen einerseits einer ersten Zeitdauer (D1A, D1B, D1C) zwischen zwei aufeinanderfolgenden Aussendezeitpunkten (IeA(1), IeA(2), IeB(1), IeB(2), IeC(1), IeC(2)) und andererseits einer zweiten Dauer (D2A, D2B; D2C) zwischen zwei entsprechenden Empfangszeitpunkten (IrA(1), IrA(2), IrB(1), IrB(2), IrC(1), IrC(2)) umfasst.

8. System nach dem vorhergehenden Anspruch, bei dem jedes Messmodul (16A), das mit einem Detektionselement (38A) ausgerüstet ist, vierte Mittel (73A) zur Berechnung einer Übertragungsdauer (DtA) umfasst, wobei die vierten Berechnungsmittel (73A) geeignet sind, jedem Detektionszeitpunkt (Id1A) einen folgenden Aussendezeitpunkt (Ie-A(2)) nach dem Detektionszeitpunkt zuzuordnen und die Übertragungsdauer (DtA) zwischen dem Detektionszeitpunkt und dem folgenden Aussendezeitpunkt zu berechnen, wobei die zyklische Nachricht (MtA(2)) die Übertragungsdauer (DtA) umfasst.

9.  System nach dem vorhergehenden Anspruch, bei dem die ersten Bestimmungsmittel (82) geeignet sind, in Bezug auf den zweiten Ausgangszeitpunkt (102) und abhängig von der zweiten Frequenz (F2) den Wert des Detektionszeitpunkts (Id2) abhängig von der Übertragungsdauer (DtA), dem Wert des Empfangszeitpunkts (IrA(2)) und des Verhältnisses (RA(2)) zu berechnen.

10. System nach einem beliebigen der Ansprüche 7 bis 10, bei dem die ersten Bestimmungsmittel (82) geeignet sind, für jedes Messmodul (16A, 16B, 16C) eine dritte Dauer (D3A, D3B, D3C) zwischen dem Empfangszeitpunkt einer von dem Messmodul gesendeten letzten zyklischen Nachricht (MtA(2), MtB(2), MtC(2)) und dem Detektionszeitpunkt (Id2), der in Bezug auf den zweiten Ausgangszeitpunkt (102) und abhängig von der zweiten Frequenz (F2) berechnet wurde, zu berechnen, und in Bezug auf den ersten Ausgangszeitpunkt und die erste Frequenz (F1A, F1B, F1C) jedes Messmoduls (16A, 16B, 16C) den Wert des Detektionszeitpunkts (Id1B, Id1C) abhängig von dem Aussendezeitpunkt (IeA(2), IeB(2), IeC(2)) der letzten zyklischen Nachricht, des entsprechenden Verhältnisses (RA(2), RB(2), RC(2)) und der dritten entsprechenden Dauer (D3A, D3B, D3C) zu bestimmen.

11. System nach dem vorhergehenden Anspruch, bei dem die Beschaffungseinheit (18) für jedes Messmodul (16A, 16B, 16C) Mittel (86) zum Definieren des ersten entsprechenden vorbestimmten Intervalls (T1A, T1B, T1C) abhängig von dem entsprechenden Verhältnis (RA(2), RB(2), RC(2)), einer dritten entsprechenden Dauer (D3A, D3B, D3C) und der Aussendezeit (Ie4A(2), IeB(2), IeC(2)) einer letzten zyklischen Nachricht in Bezug auf den ersten Ausgangszeitpunkt (I01A, I01B, I01C) und abhängig von der ersten Frequenz (F1A, F1B, F1C) umfasst.

12. System nach einem beliebigen der vorhergehenden Ansprüche, bei dem jedes Messmodul ein Abtastelement (30A, 30B, 30C) umfasst, das geeignet ist, die gemessenen Werte jeder elektrischen Größe gemäß einer Abtastfrequenz ($F_{ECH}$) abzutasten, wobei eine Abtastzahl und der erste entsprechende Messzeitpunkt (Im1A, Im1B, Im1C) jeder Abtastung zugeordnet ist,

bei dem die Beschaffungsmittel (90) geeignet sind, jedem Messmodul über eine Auswahlnachricht (MselA, MselB, MselC) das erste entsprechende Intervall zu übertragen, und

bei dem jedes Messmodul geeignet ist, der Beschaffungseinheit über eine Beschaffungsnachricht (sMdA(1), MdB(1), MdC(1)) die Abtastungen, deren erster Zeitpunkt in dem ersten korrespondierenden empfangenden Intervall enthalten sind, und mindestens eine zweite Variable (V2A, V2B, V2C) relativ zum ersten Messzeitpunkt einer der Abtastungen, zu übertragen.

13. Verfahren zum Detektieren eines elektrischen Fehlers in einer elektrischen Anlage, die mehrere elektrische Leitungen (14A, 14B, 14C) umfasst, wobei das Verfahren mit Hilfe eines Systems zur Detektion eines elektrischen Fehlers durchgeführt wird, umfassend:

   - mindestens zwei Messmodule (16A, 16B, 16C), wobei jedes Messmodul (16A, 16B, 16C) erste Funkkommunikationsmittel (24A, 26A, 24B, 26B, 24C, 26C), einen Sensor (22A, 22B, 22C) zum Messen jeder elektrischen Größe, die einer entsprechenden elektrischen Leitung (14A, 14B, 14C) zugeordnet ist, und eine erste Uhr (34A, 34B, 34C), die durch einen ersten Anfangszeitpunkt (I01A, I01B, I01C) und eine erste Uhrfrequenz (F1A, F1B, F1C) definiert ist, aufweist, wobei jeder gemessene Wert geeignet ist, einem ersten Messzeitpunkt (Im1A, Im1B, Im1C) zugeordnet zu werden, der in Bezug auf den ersten Anfangszeitpunkt (I01A, I01B, I01C) und abhängig von der ersten Frequenz (F1A, F1B , F1C) bestimmt ist,
   - eine Einheit (18) zum Beschaffen von gemessenen Wert, die zweite Funkkommunikationsmittel (40, 42) aufweist, die geeignet sind, mit den ersten Funkkommunikationsmitteln (24A, 26A, 24B, 26B, 24C, 26C) zu kommunizieren,

   **dadurch gekennzeichnet, dass** das Verfahren für mindestens eines der Messmodule die folgenden Schritte umfasst

   - a) Detektieren (204) des elektrischen Fehlers an der entsprechenden elektrischen Leitung,
   - b) Bestimmen (204) des Werts eines Detektionszeitpunkts des Fehlers in Bezug auf einen ersten Ausgangszeitpunkt und abhängig von der ersten Frequenz,

und dass das Verfahren die folgenden Schritte umfasst:

- c) durch die Beschaffungseinheit Bestimmen (214) des Werts jedes Detektionszeitpunkts in Bezug auf den ersten Ausgangszeitpunkt (I01B; I01C) und abhängig von der ersten Frequenz (F1B, F1C) der anderen Messmodule,
- d) durch die Beschaffungseinheit Beschaffen (214) von einzelnen gemessenen Werten für jedes Messmodul, für die der erste Messzeitpunkt in einem ersten vorbestimmten entsprechenden Zeitintervall (T1A, T1B, T1C) umfasst ist, wobei jedes erste entsprechende Intervall den Wert des Detektionszeitpunkts umfasst, der für das Messmodul bestimmt wird.

14. Verfahren nach Anspruch 13, bei dem die Beschaffungseinheit (18) eine zweite Uhr (48) aufweist, die durch einen zweiten Ausgangszeitpunkt und eine Uhrfrequenz definiert ist, und wobei bei dem Beschaffungsschritt d) das Verfahren den folgenden Schritt umfasst:

- e) Berechnen (216) für jeden beschafften Werteines zweiten Messzeitpunkts (Im2A, Im2B, Im2C) des Werts, der in Bezug auf den zweiten Ausgangszeitpunkt (102) und abhängig von der zweiten Frequenz (F2) bestimmt wird.

15. Verfahren nach einem beliebigen der vorhergehenden Ansprüche, bei dem vor dem Schritt des Bestimmens b) das Verfahren einen Schritt (d1) des Identifizierens (213) umfasst, während dem die Beschaffungseinheit (18) überprüft, ob eines der Messmodule den elektrischen Fehler detektiert hat oder nicht, und bei dem Schritte des Bestimmens c) und des Beschaffens d) nur durchgeführt werden, wenn das Auftauchen des elektrischen Fehlers bei dem Identifizierungsschritt identifiziert wird.

## Claims

1. System (12) for detecting an electrical fault in an electrical installation comprising a plurality of electrical conductors (14A, 14B, 14C), the system comprising:

- at least two measuring modules (16A, 16B, 16C), each measuring module (16A, 16B, 16C) comprising first radioelectric communication means (24A, 26A, 24B, 26B, 24C, 26C), a sensor (22A, 22B, 22C) for measuring each electrical parameter associated with a corresponding electrical conductor (14A, 14B, 14C), and a first clock (34A, 34B, 34C) defined by a first initial instant (I01A, I01B, I01C) and a first clock frequency (F1A, F1B, F1C), each measured value being capable of being associated with a first instant of measurement (Im1A, Im1B, Im1C) determined relative to the first initial instant (I01A, I01B, I01C) and as a function of the first frequency (F1A, F1B, F1C),
- an acquisition unit (18) for acquiring the measured values, comprising second radioelectric means (40, 42) adapted to communicate with the first radioelectric communication means (24A, 26A, 24B, 26B, 24C, 26C),

characterised in that the system comprises, for at least one of the measuring modules (16A), a member (38A) for detecting the electrical fault associated with the corresponding electrical conductor (14A), the detection member (38A) being capable of determining the value of an instant of detection (Id1A) of the fault relative to the first initial instant and as a function of the first frequency,
in that the acquisition unit comprises:

- first means (82) for determining the value of each instant of detection relative to the first initial instant (I01B, 101C) and as a function of the first frequency (F1B, F1C) of the other measuring modules (16A, 16B, 16C),
- acquisition means (90) for each measuring module for acquiring only those measured values for which the first instant of measurement (Im1A, Im1B, Im1C) is within a corresponding first predefined time interval (T1A, T1B, T1C), each corresponding first interval (T1A, T1 B, T1C) comprising the value of the instant of detection (Id1A, Id1B, Id1C) determined for said measuring module with which it is associated.

2. System according to claim 1, wherein the acquisition unit (18) comprises a second clock (48) defined by a second initial instant (I02) and a second clock frequency (F2), and wherein the first determination means (82) are capable of determining the value of the instant of detection, relative to the second initial instant (102) and as a function of the second frequency (F2).

3. System according to claim 1 or 2, wherein the acquisition unit comprises a second clock (48) defined by a second initial instant (I02) and a second clock frequency (F2), and wherein the acquisition unit comprises second means (84) for determining, for each acquired value, a second instant (Im2A, Im2B, Im2C) of measurement of said value, determined relative to the second initial instant (I02) and as a function of the second frequency (F2).

4. System according to claim 3, wherein the acquisition unit (18) comprises first calculation means (94) capable of calculating a series of third instants which are regularly spaced and determined relative to the second initial instant (I02) and as a function of the second frequency (F2), and second calculation means (96) capable of estimating the value of each electrical parameter measured, at the third instants and as a function of the acquired values and of the second instants of measurement (Im2A, Im2B, Im2C).

5. System according to any one of the preceding claims, wherein the electrical parameter or parameters is/are chosen from a voltage and a current.

6. System according to claim 3 or 4 and according to claim 5, wherein the acquisition unit (18) comprises confirmation means (98) adapted to confirm the occurrence of the electrical fault as a function of the acquired values and of the associated second instants of measurement (Im2A, Im2B, Im2C).

7. System according to any one of claims 2 to 6, wherein each measuring module comprises generating means (71A, 71B, 71C) for generating a cyclic message (MtA(1), MtA(2), MtB(1), MtB(2), MtC(1), MtC(2)), comprising a first variable (V1A, V1B, V1C), which is a function of an instant of emission of the cyclic message (IeA(1), IeA(2), IeB(1), IeB(2), IeC(1), IeC(2)) relative to the first initial instant (I01A, I01B, I01C) and according to the first frequency (F1A, F1B, F1C), and transmission means (72A, 72B, 72C) for transmitting the cyclic message to the acquisition unit (MtA(1), MtA(2), MtB(1), MtB(2), MtC(1), MtC(2)), wherein the acquisition unit (18) is capable of determining an instant of receipt of the cyclic message (IrA(1), IrA(2), IrB(1), IrB(2), IrC(1), IrC(2)), relative to the second initial instant (I02) and as a function of the second frequency (F2), and wherein, for each measuring module (16A, 16B, 16C), the acquisition unit (18) comprises third means (97) for calculating a ratio (RA(2), RB(2), RC(2)) between, on the one hand, a first duration (D1 A, D1 B, D1 C) between two successive instants of emission (IeA(1), IeA(2), IeB(1), IeB(2), IeC(1), IeC(2)) and, on the other hand, a second duration (D2A, D2B, D2C) between two corresponding instants of receipt (IrA(1), IrA(2), IrB(1), IrB(2), IrC(1), IrC(2)).

8. System according to the preceding claim, wherein each measuring module (16A) equipped with a detection member (38A) comprises fourth means (73A) for calculating a duration of transmission (DtA), the fourth calculating means (73A) being capable of associating with each instant of detection (Id1A) a following instant of emission (IeA(2)), after the instant of detection, and of calculating the duration of transmission (DtA) between the instant of detection and the following instant of emission, the cyclic message (MtA(2)) comprising the duration of transmission (DtA).

9. System according to the preceding claim, wherein the first determining means (82) are capable of calculating, relative to the second initial instant (I02) and as a function of the second frequency (F2), the value of the instant of detection (Id2) as a function of the duration of transmission (DtA), of the value of the instant of receipt (IrA(2)) and of the ratio (RA(2)).

10. System according to any one of claims 7 to 10, wherein the first determination means (82) are capable of calculating, for each measuring module (16A, 16B, 16C), a third duration (D3A, D3B, D3C) between the instant of receipt of a last cyclic message (MtA(2), MtB(2), MtC(2)) transmitted by the measuring module and the instant of detection (Id2) calculated relative to the second initial instant (I02) and as a function of the second frequency (F2), and of determining, relative to the first initial instant and to the first frequency (F1A, F1B, F1C) of each measuring module (16A, 16B, 16C), the value of the instant of detection (Id1 B, Id1C) as a function of the instant of emission (IeA(2), IeB(2), IeC(2)) of the last cyclic message, of the corresponding ratio (RA(2), RB(2), RC(2)) and of the corresponding third duration (D3A, D3B, D3C).

11. System according to the preceding claim, wherein the acquisition unit (18) comprises, for each measuring module (16A, 16B, 16C), means (86) for defining the corresponding first predefined interval (T1A, T1B, T1C) as a function of the corresponding ratio (RA(2), RB(2), RC(2)), of a corresponding third duration (D3A, D3B, D3C) and of the time of emission (IeA(2), IeB(2), IeC(2)) of a last cyclic message relative to the first initial instant (I01A, I01B, I01C) and as a function of the first frequency (F1A, F1B, F1C).

12. System according to any one of the preceding claims, wherein each measuring module comprises a sampling member (30A, 30B, 30C) capable of sampling the measured values of each electrical parameter according to a sampling frequency ($F_{ECH}$), a sample number and the corresponding first instant of measurement (Im1A, Im1B, Im1C) being associated with each sample,

wherein the acquisition means (90) are capable of transmitting to each measuring module, *via* a selection message (MselA, MselB, MselC), the corresponding first interval, and

wherein each measuring module is capable of transmitting to the acquisition unit, *via* an acquisition message (MdA(1), MdB(1), MdC(1)), the samples whose first instant is within the corresponding first interval received and at least a second variable (V2A, V2B, V2C) relating to the first instant of measurement of one of the samples.

13. Method for detecting an electrical fault in an electrical installation comprising a plurality of electrical conductors (14A, 14B, 14C), the method being carried out by means of a system for detecting the electrical fault comprising:

- at least two measuring modules (16A, 16B, 16C), each measuring module (16A, 16B, 16C) comprising first radioelectric communication means (24A, 26A, 24B, 26B, 24C, 26C), a sensor (22A, 22B, 22C) for measuring each electrical parameter associated with a corresponding electrical conductor (14A, 14B, 14C), and a first clock (34A, 34B, 34C) defined by a first initial instant (I01A, I01B, I01C) and a first clock frequency (F1A, F1B, F1C), each measured value being capable of being associated with a first instant of measurement (Im1A, Im1B, Im1C) determined relative to the first initial instant (I01A, I01B, I01C) and as a function of the first frequency (F1A, F1B, F1C),
- an acquisition unit (18) for acquiring the measured values, comprising second radioelectric communication means (40, 42) adapted to communicate with the first radioelectric means (24A, 26A, 24B, 26B, 24C, 26C),

**characterised in that** the method comprises, for at least one of the measuring modules, the following steps:

- a) detection (204) of the electrical fault on the corresponding electrical conductor,
- b) determination (204) of the value of an instant of detection of the fault relative to the first initial instant and as a function of the first frequency,

and **in that** the method comprises the following steps:

- c) determination (214) by the acquisition unit of the value of each instant of detection relative to the first initial instant (I01B, I01C) and as a function of the first frequency (F1 B, F1 C) of the other measuring modules,
- d) acquisition (214), by the acquisition unit and for each measuring module, of only those measured values for which the first instant of measurement is within a corresponding first predefined time interval (T1A, T1B, T1C), each corresponding first interval comprising the value of the instant of detection determined for said measuring module.

14. Method according to claim 13, wherein the acquisition unit (18) comprises a second clock (48) defined by a second initial instant and a second clock frequency, and wherein, in the step of acquisition d), the method comprises the following step:

- e) calculation (216), for each acquired value, of a second instant (Im2A, Im2B, Im2C) of measurement of the value, determined relative to the second initial instant (I02) and as a function of the second frequency (F2).

15. Method according to any one of the preceding claims, wherein, prior to the step of determination b), the method comprises a step d1) of identification (213) in which the acquisition unit (18) verifies if one of the measuring modules has or has not detected the electrical fault, and wherein the steps of determination c) and of acquisition d) are carried out only if the occurrence of the electrical fault is identified in the step of identification.

FIG.1

_FIG.2_

EP 3 001 208 B1

FIG.3

| Démarrage du système d'acquisition | 200 |

↓

| Initialisation | 202 |

↓

| Vérification de l'apparition ou non d'un défaut électrique | 204 |

↓

| Transmission du message de synchronisation | 206 |

↓

| Génération et émission des messages cydiques | 208 |

↓

| Mémorisation de l'instant de réception | 210 |

↓

| Calcul des ratios | 212 |

↓

| Identification de l'apparition du défaut électrique par l'unité d'acquisition | 213 |

↓

| Acquisition des valeurs d'intensité du courant | 214 |

↓

| Calcul des valeurs aux deuxièmes et troisièmes instants | 216 |

↓

| Confirmation ou non de l'apparition du défaut électrique | 218 |

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2991057 A1